# EUROPEAN PATENT APPLICATION

(11) **EP 3 416 184 A1**
(43) Date of publication of application: **19.12.2018**
(21) Application number: 17175955.8
(22) Date of filing: 14.06.2017
(51) Int. Cl.: H01L 21/329, H01L 29/872, H01L 29/06, H01L 29/16, H01L 21/308

(54) **HIGH POWER SEMICONDUCTOR DEVICE WITH MESA TERMINATION STRUCTURE AND METHOD FOR MANUFACTURING THE SAME**

(71) Applicant: ABB Schweiz AG, 5400 Baden (CH)
(72) Inventor: Mihaila, Andrei, 5400 Baden (CH); Knoll, Lars, 5512 Wohlenschwil (CH); Kranz, Lukas, 8050 Zürich (CH)
(74) Representative: ABB Patent Attorneys

(57) **Abstract**

The method of the invention comprises a step of providing a silicon carbide layer (1) having a first main side (2) and a second main side (3) opposite to the first main side (2), wherein the first and the second main side (2, 3) extend in parallel to a lateral direction and wherein the silicon carbide layer (1) comprises an active region (AR) and a termination region (TR) laterally surrounding the active region (AR); a step of forming a first patterned metal layer (5') on the first main side (2) of the silicon carbide layer (1) in the active region (AR), the first patterned metal layer (5') exposing the termination region (TR); and a step of anisotropic etching of the silicon carbide layer (1) in areas where the silicon carbide layer (1) is exposed by the patterned first metal layer (5') to form a recess (11) in the silicon carbide layer (1) in the termination region (TR).

## Description

### FIELD OF THE INVENTION

The present invention relates to a high power semiconductor device comprising a recess in the termination region (mesa termination structure) and to a method for manufacturing the same.

### BACKGROUND OF THE INVENTION

Semiconductor devices, in particular high power semiconductor devices, require an efficient edge termination to avoid electric field crowding at the edge of the main contact resulting in breakdown of the device at a relatively low breakdown voltage VBR.

Floating field rings and the junction termination extension are the most commonly used edge termination techniques in silicon carbide (SiC) based high power devices. The floating field ring termination structure has the advantage that the generation of floating field rings can be easily integrated in the manufacturing process since the floating field rings can be formed simultaneously with a main junction in many power semiconductor devices. Accordingly, it is possible to form the floating field rings without having to increase the necessary number of masks. On the other hand, the design of a high performance floating field ring termination is very challenging given the high number of factors affecting the most important trade-off between breakdown voltage and occupied wafer area. This trade-off is strongly affected by interface trapped charges (technology impact) and by design parameters, such as the lateral width and depth of the floating field rings or the distance between two neighbouring floating field rings.

In conventional SiC junction barrier Schottky (JBS) diodes of all commercially available voltage classes the formation of the active region (AR) as well as the termination region (TR) require multiple implantation steps to form highly doped p⁺ regions and typically a deep p⁻ ring in the termination region. Moreover, after the implantation steps a surface protection has to be deposited before the implanted dopants can be activated at a temperature of typically more than 1600°C. These implantation steps require high temperature implantation facilities and an annealing oven especially designed for SiC activation, which makes the fabrication comparably costly. Also the quality of the SiC surface and therewith the device yield has been found to be degraded during the activation.

Bearing in mind the technologically difficult and expensive processing, besides the processing cost reduction an implantation free design would enable fabrication of SiC based rectifiers in conventional silicon cleanrooms.

From the article "Process Variation Tolerant 4H-SiC Power Devices Utilizing Trench Structures" by Hossein Elahipanah et al., Materials Science Forum Vols. 740-742 (2013) pp 809-812, there is known a SiC pn diode wherein trenches are formed in a termination region of the SiC pn diode to diminish the effect of process variations in terms of doping concentration and etching depth. It is said in this article that the proposed structure can be realized by an etching process and hence the fabrication steps could be free of ion implantation and degradation in current capability.

From the prior art document US 7 960 198 B2 there are known SiC based diodes including Schottky barrier diodes and bipolar junction diodes, which have a mesa edge termination, and methods for manufacturing the same. In the manufacturing method described in this prior art document the Schottky contact metal and the front-side final metal are formed only after a plasma etching process for forming the mesa edge termination and are patterned in separate steps. The outer circumferential edges of the Schottky contact metal and of the front-side metal are, therefore, not aligned with the sidewalls of the mesa edge termination. A variation of the distance between the sidewall of the edge termination and the outer edge of the Schottky metal results in a variation of the area efficiency of the device. In addition, forming a mesa edge termination by a deep vertical SiC etch is challenging for conventional photoresist. Accordingly, it is difficult in the known method for manufacturing a SiC based diode having a mesa edge termination structure with sidewalls that are steep enough to provide an efficient edge termination.

### SUMMARY OF THE INVENTION

It is the object of the invention to provide a high power semiconductor device with an area efficient and effective edge termination as well as a method for manufacturing the same that does not require any additional implantation step.

The object of the invention is attained by a method for manufacturing a power semiconductor device according to claim 1. The method of the invention comprises a step of providing a silicon carbide layer having a first main side and a second main side opposite to the first main side, wherein the first and the second main side extend in parallel to a lateral direction and wherein the silicon carbide layer comprises an active region and a termination region laterally surrounding the active region; a step of forming a first patterned metal layer on the first main side of the silicon carbide layer in the active region, the first patterned metal layer exposing the termination region; and a step of anisotropic etching of the silicon carbide layer in areas where the silicon carbide layer is exposed by the patterned first metal layer to form a recess in the silicon carbide layer in the termination region. Throughout the specification a lateral direction refers to a direction parallel to the first main side and laterally means relating to a lateral direction.

As in the method of the invention areas that are exposed by the patterned first metal layer are etched in the step of anisotropic etching, an outer circumferential edge of the patterned first metal layer is self-aligned with a sidewall of the recess formed in the step of anisotropic etching. The recess formed in the step of anisotropic etching forms a mesa edge termination by a process free of any implantation step. The patterned first metal layer can protect areas of the SiC layer that shall not be etched during the step of anisotropic etching in a relatively reliable manner because the metal is more resistant to etchants used in the step of anisotropic etching. Accordingly, a deep SiC etch can be performed more reliably.

Further developments of the invention are specified in the dependent claims.

In an exemplary embodiment the patterned first metal layer is used as a first etching mask in the step of anisotropic etching of the silicon carbide layer. Using the patterned first metal layer as an etching mask in the step of anisotropic etching is advantageous compared to using an etching mask made of photoresist as metal is more resistant to etchants, that are used in the step of anisotropic etching of the silicon carbide layer, than photoresist.

In an exemplary embodiment the method further comprises a step of forming a second patterned metal layer in direct contact with the silicon carbide layer to form a Schottky contact with the silicon carbide layer, wherein the first patterned metal layer is in direct contact with the second patterned metal layer to form an ohmic contact with the second patterned metal layer. The second patterned metal layer is arranged between the silicon carbide layer and the first patterned layer. Thus, the second patterned metal layer is formed before the first patterned metal layer. With this additional method step it is possible to form a Schottky diode.

In an exemplary embodiment the first patterned metal layer is made of aluminium or nickel. These metals are especially resistant to common anisotropic etching processes for etching SiC. In addition, these metals can be used as contact electrodes for electrically contacting the manufactured power semiconductor device.

In an exemplary embodiment a fluorine (F) based etching gas is used in the step of anisotropic etching of the silicon carbide layer. A fluorine (F) based etching gas can etch SiC with a relatively high etch selectivity against metal. In particular, it has an especially high etch selectivity against aluminium and nickel.

In an exemplary embodiment the step of forming the first patterned metal layer is performed by deposition of metal through a shadow mask or by a lift-off technique. These techniques allow to form the first patterned metal layer without having to use a photoresist mask.

In an exemplary embodiment the step of forming the first patterned metal layer comprises the following steps: forming a first continuous metal layer on the first main side of the silicon carbide layer in the active region and in the termination region; forming a second etching mask on the first metal layer at least in the termination region; and etching of the first continuous metal layer using the second etching mask to form the first patterned metal layer. In this exemplary embodiment the second etching mask defines the pattern of the first patterned metal layer and the position of the recess formed in the step of anisotropic etching the silicon carbide layer.

In an exemplary embodiment the second etching mask is a photoresist mask. Patterning the first continuous metal layer by using a photoresist mask is a well advanced and cost efficient technology.

In another exemplary embodiment the second etching mask is a hard mask. A hard mask is more resistant to common etching processes, resulting in a well-defined sidewall of the recess formed in the step of anisotropic etching of the silicon carbide layer even when the hard mask is not removed before the step of anisotropic etching of the silicon carbide layer.

In an exemplary embodiment the etching of the first continuous metal layer is anisotropic. In such exemplary embodiment the pattern of the first patterned metal layer is formed with high precision.

In an exemplary embodiment a chlorine (CI) based etching gas is used in the step of etching of the first continuous metal layer. Chlorine (CI) based etching gas is especially efficient for etching metals.

In an exemplary embodiment etching of the first continuous metal layer is isotropic. An isotropic etching process is easy to perform and also more economic.

In an exemplary embodiment the second etching mask is removed before the step of anisotropic etching of the silicon carbide layer. In such exemplary embodiment only the first patterned metal layer acts as an etching mask in the step of anisotropic etching of the silicon carbide layer. Such exemplary embodiment can achieve an especially well defined sidewall of the recess formed in the silicon carbide layer to obtain a higher breakdown voltage of the power semiconductor device.

In another exemplary embodiment the second etching mask is removed during the step of anisotropic etching of the silicon carbide layer. In such embodiment the method for manufacturing the power semiconductor device is more economic.

In an exemplary embodiment, the doping concentration of the silicon carbide layer (1) is 10¹⁷ cm⁻³ or less, and in the step of etching the silicon carbide layer, the silicon carbide layer is etched to a depth of at least 30% of a layer thickness of the silicon carbide layer, wherein the layer thickness is a distance from the first main side to the second main side in a direction orthogonal to the first main side. Such depth of the recess in the termination area can provide an efficient mesa edge termination to obtain a relatively high breakdown voltage of the power semiconductor device.

The object is also attained by a power semiconductor device according to claim 15. The power semiconductor device of the invention comprises: a silicon carbide layer, the silicon carbide layer having a first main side and a second main side opposite to the first main side, wherein the first and the second main side extend in parallel to a lateral direction and wherein the silicon carbide layer comprises an active region and a termination region laterally surrounding the active region, wherein the silicon carbide layer has a recessed portion, which is recessed from the first main side, in the termination region; and a first patterned metal layer on a first main side of the silicon carbide layer in the active region. Exemplarily, no metal layer is arranged in the termination region on the first main side. The power semiconductor device of the invention is characterized in that a sidewall of the recessed portion adjacent to the active region is laterally aligned with a circumferential edge of the first patterned metal layer. The power semiconductor device of the invention is more area efficient and can be manufactured by any one of the above mentioned methods.

### BRIEF DESCRIPTION OF THE DRAWINGS

Detailed embodiments of the invention will be explained below with reference to the accompanying figures, in which:
- Figs. 1 A to 1I: illustrate method steps in a method for manufacturing a power semiconductor device according to a first embodiment of the invention;
- Figs. 2: illustrate a method step in a modified first embodiment of the invention;
- Figs. 3A to 3E: illustrate method steps in a method for manufacturing a power semiconductor device according to a second embodiment of the invention; and
- Figs. 4A and 4B: illustrate method steps in a method for manufacturing a power semiconductor device according to a third embodiment of the invention.

The reference signs used in the figures and their meanings are summarized in the list of reference signs. Generally, similar elements have the same reference signs throughout the specification. The described embodiments are meant as examples and shall not limit the scope of the invention.

### Detailed Description of preferred embodiments

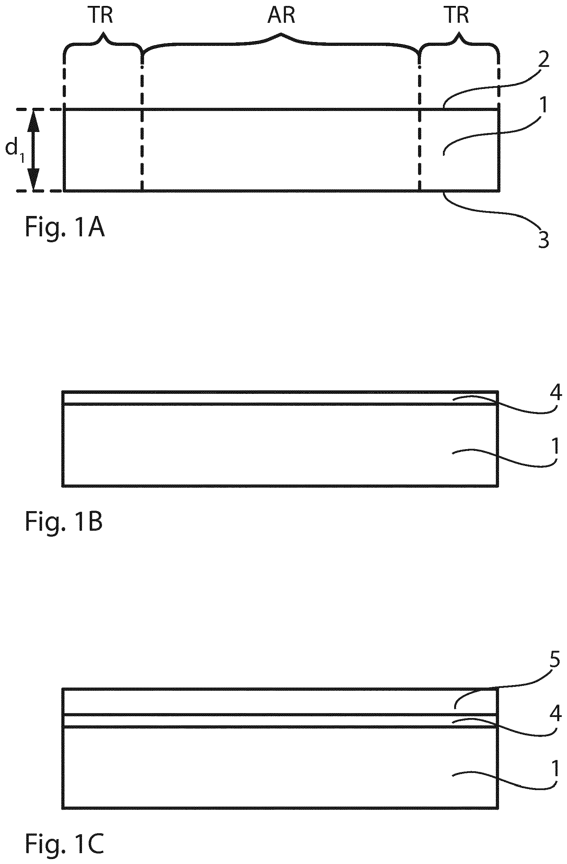

In the following there is explained a method for manufacturing a power semiconductor device according to a first embodiment of the invention with reference to Figs. 1A to 1I. In the first embodiment the power semiconductor device is a Schottky diode.

In a first method step illustrated in Fig. 1A there is provided an n-type silicon carbide (SiC) layer 1. The SiC layer 1 has exemplarily a relatively low doping concentration of 10¹⁷ cm⁻³ or less and forms the drift layer in the final power semiconductor device. Appropriate doping profiles of the SiC layer 1 for use in a Schottky diode are well known in the prior art. The SiC layer 1 has a first main side 2 and a second main side 3 as shown in Fig. 1A. The first main side 2 and the second main side 3 extend in a lateral direction. The SiC layer 1 comprises an active region AR and a termination region TR laterally surrounding the active region AR. The SiC of the SiC layer 1 may be any polytype of SiC such as 4H-SiC, 6H-SiC or 3C-SiC, for example. A layer thickness d_{SiC} of the SiC layer 1 depends on the nominal blocking voltage of the power semiconductor device, wherein the layer thickness d_{SiC} of the SiC layer 1 is defined as the shortest distance between the first and the second main side 2, 3 in the termination region TR.

A Schottky contact metal layer 4 is formed on the entire first main side 2 of the SiC layer 1 to form a Schottky contact with the SiC layer 1 in the active region AR and in the termination region TR as illustrated in Fig. 1B. Any metal appropriate for a Schottky contact may be used as a material of the Schottky contact metal layer 4. Titanium (Ti) or nickel (Ni) are known as materials appropriate for a Schottky contact to SiC and may be used for the Schottky contact metal layer 4, for example. Also, the Schottky contact metal layer 4 may comprise an alloy or different metals in a stack of layers.

Thereafter a front side electrode layer 5 (which is an example for a first continuous metal layer in the claims) is formed on the Schottky contact metal layer 4 to form an ohmic contact to the Schottky contact metal layer 4 as illustrated in Fig 1C. The front side electrode layer 5 is a metal layer such as an aluminium (Al) or nickel (Ni) layer.

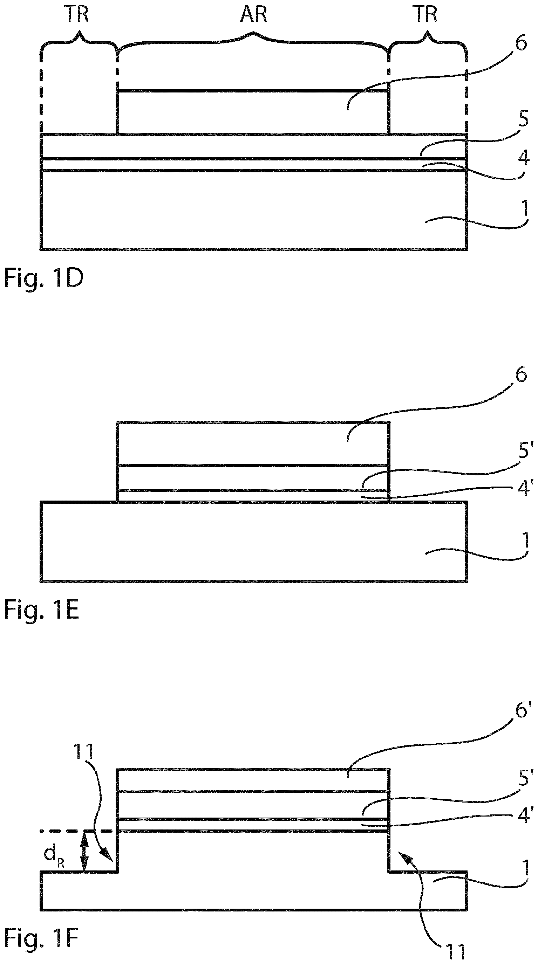

In a next step a photoresist mask 6 (which is an example for a second etching mask in the claims) is formed on the front side electrode layer 5 to obtain the structure as shown in Fig. 1D. The photoresist mask 6 is formed in the active region AR to expose the front side electrode layer 5 in the termination region TR.

Using the photoresist mask 6 as an etching mask the front side electrode layer 5 and the Schottky contact metal layer 4 are removed by anisotropic etching in the termination region TR. The anisotropic etching may be performed by reactive ion etching (RIE) using a chlorine (CI) based etching gas, for example. The resulting structure after the step of anisotropic etching is shown in Fig. 1E. In particular, a patterned Schottky contact metal layer 4' (which is an example for a second patterned metal layer in the claims) and a patterned front side electrode layer 5' (which is an example for a first patterned metal layer in the claims) are formed in this way.

Next a recess 11 is formed in the SiC layer 1 in the termination region TR as illustrated in Fig. 1F by anisotropic etching. Therein, anisotropic etching is selective against the metal of the patterned Schottky contact metal layer 4' and the patterned front side electrode layer 5'. It may be performed by RIE using a fluorine (F) based etching gas, for example. The recess 11 is formed in areas where the SiC layer 1 is exposed by the stack of the patterned Schottky contact metal layer 4', the patterned front side electrode layer 5' and the photoresist mask 6. Accordingly, the recess 11 is formed in areas where the SiC layer 1 is not covered by (i.e. exposed by) the patterned front side electrode layer 5'. Throughout the specification a first layer formed on a second layer is meant to cover the second layer in all areas where the first layer overlaps the second layer in a orthogonal projection on a plane parallel to the first main side 2 of the SiC layer 1. The recess 11 in the termination region TR forms a mesa edge termination structure in the final power semiconductor device. In the step of anisotropic etching of SiC the photoresist mask 6 is partially removed and only a remaining portion 6' of the photoresist mask 6 remains after the step of anisotropic etching. Due to the anisotropic character of the etching process the lateral dimension of the photoresist mask 6 is not changed during the etching process, but only the thickness of the photoresist mask 6 is reduced during the etching process when forming the recess 11. In the first embodiment, in which the remaining portion 6' remains after the step of anisotropic etching, the photoresist mask 6 has the function of an etching mask in the whole step of anisotropic etching of SiC when forming the recess 11 in the termination region TR. The depth d_{R} of the recess 11 in the SiC layer 1 may be at least 30% of the layer thickness d_{SiC} of the SiC layer 1.

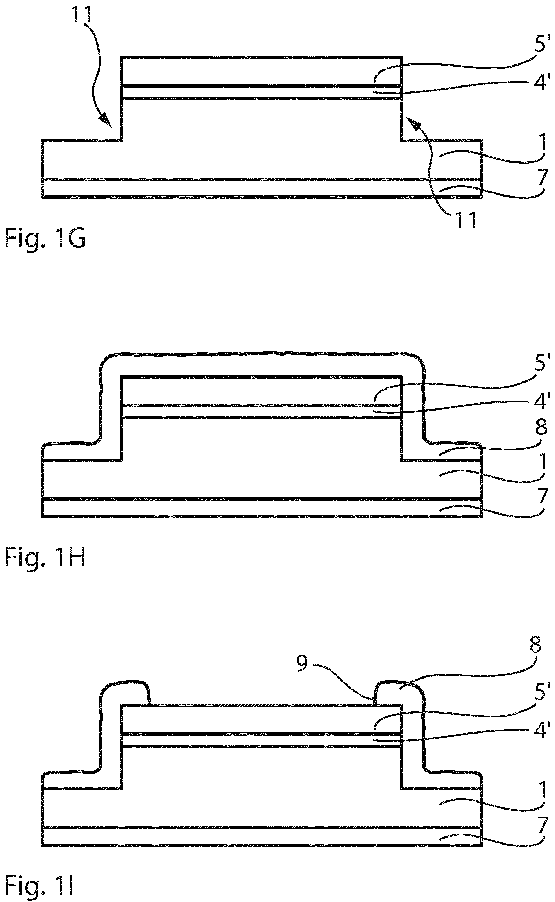

As illustrated in Fig. 1G the remaining portion 6' of the photoresist mask 6 is removed and a backside electrode layer 7 is formed on the second main side 3. Thereafter, a passivation layer 8 is formed on the whole front side of the device to obtain a structure as shown in Fig. 1H. Finally, as illustrated in Fig. 1I. an opening 9 is formed in the passivation layer 8 to expose the patterned front side electrode layer 5'for electrically contacting it from outside. Fig. 1I shows the Schottky diode as manufactured by the method according to the first embodiment.

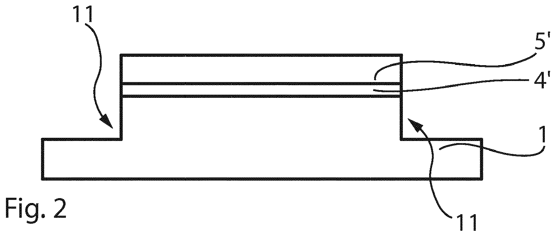

A modification of the first embodiment is described with reference to Fig. 2. Due to the many similarities of the first embodiment with the modified first embodiment only differences of the modified first embodiment to the first embodiment are discussed. The remaining features are the same as in the first embodiment and for an explanation thereof it is referred to the first embodiment discussed above with reference to Figs. 1 A to 1I. The manufacturing method according to the modified first embodiment differs from the above described embodiment only in that the photoresist mask 6 is removed after the step of forming the patterned Schottky contact metal layer 4' and the patterned front side electrode layer 5' by anisotropic etching and before the step of anisotropic etching of the SiC layer 1 for forming the recess 11. Accordingly, in this modified first embodiment the patterned front side electrode layer 5' acts as an etching mask during the step of forming the recess 11 in the SiC layer 1 by anisotropic etching. Fig. 2 shows the device structure immediately after the step of anisotropic etching of the SiC layer 1. In contrast to the device structure shown in Fig. 1F there is no remaining portion 6' after the step of anisotropic etching of the SiC layer 1.

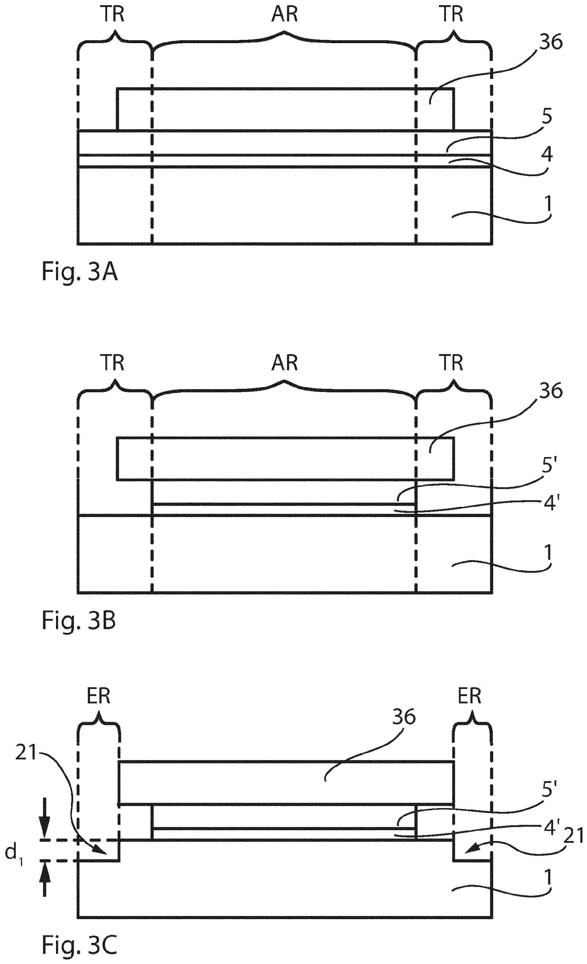

In the following a second embodiment of the method for manufacturing a power semiconductor device is described with reference to Figs. 3A to 3E. Due to the many similarities of the second embodiment with the first embodiment only differences of the second embodiment to the first embodiment are discussed. The remaining features are the same as in the first embodiment and for an explanation thereof it is referred to the first embodiment discussed above with reference to Figs. 1A to 1I.

In the second embodiment first a structure as shown in Fig. 1C is formed by the same method steps as discussed above. Then a photoresist mask 36 is formed that has greater lateral extension, i.e. it covers also part of the termination region TR as shown Fig. 3A.

Thereafter the patterned Schottky contact metal layer 4' and the patterned front side electrode layer 5' are formed by isotropic etching such as by wet chemical etching of a portion of the front side electrode layer 5 and of the Schottky contact metal layer 4 covering the termination region TR to obtain the structure as shown in Fig. 3B.

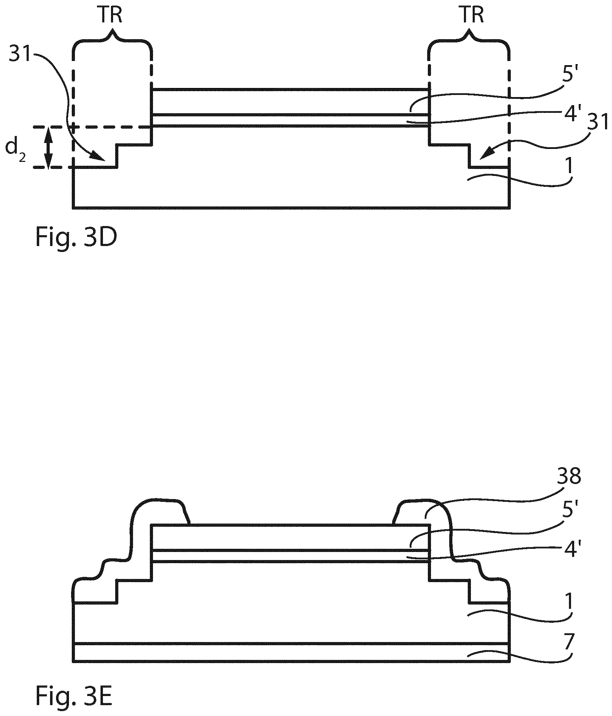

In a next step the SiC layer 1 is anisotropically etched. The etching is performed with etch selectivity against the materials of the patterned Schottky contact metal layer 4' and of the patterned front side electrode layer 5'. It may be perfomed by RIE using a fluorine (F) based etching gas, for example. During the etching process the thickness of the photoresist mask 36 is more and more reduced until it is totally removed. Until the photoresist mask 36 is removed in the anisotropic etching, the photoresist mask 36 acts as an etching mask as shown in Fig. 3C and material of the SiC layer 1 is removed by the anisotropic etching only in a recess region ER that is a part of the termination region TR that is not covered by the photoresist mask 36 to form a recess 21 in the SiC layer 1. From a moment when the photoresist mask 36 is totally removed by the anisotropic etching, the patterned front side electrode layer 5' acts as an etching mask and material of the SiC layer 1 is removed in all areas where the SiC layer 1 is not covered by the patterned front side electrode layer 5'. In this way a stepped recess 31 is formed in the termination region TR as shown in Fig. 3D. The stepped recess 31 has a depth d₂ in the recess region ER of the termination region TR, wherein the depth d₂ may be at least 30% of the layer thickness of the SiC layer 1, and has a depth d₁-d₂ in other areas of the termination region TR, wherein d₁ is the depth of a recess 21 formed at the moment when the photoresist mask 36 is totally removed by the anisotropic etching.

Finally, a back side electrode layer 7 and a passivation layer 38 exposing the patterned front side electrode layer 5' through an opening therein is formed similar to the first embodiment to obtain the structure as shown in Fig. 3E.

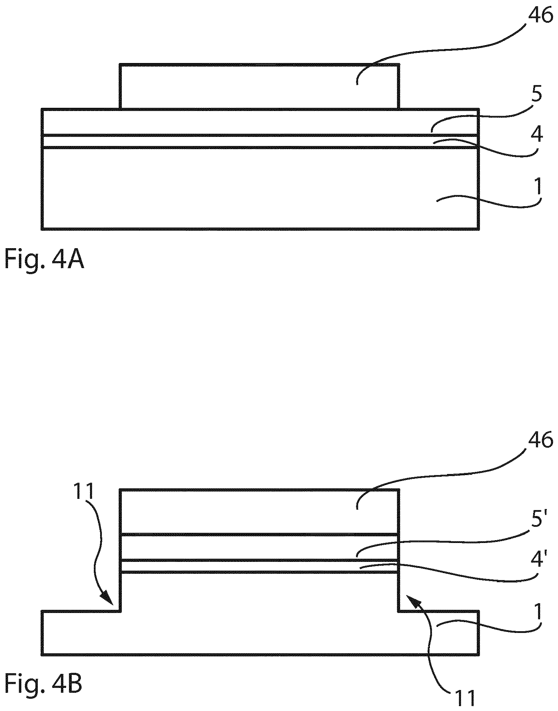

In the following a third embodiment of the method for manufacturing a power semiconductor device is described with reference to Figs. 4A and 4B. Due to the many similarities of the third embodiment with the first embodiment only differences of the third embodiment to the first embodiment are discussed. The remaining features are the same as in the first embodiment and for an explanation thereof it is referred to the first embodiment discussed above with reference to Figs. 1A to 1I.

Starting from a structure as shown in Fig. 1C a hard mask 46, which is e.g. made of silicon oxide or silicon nitride, is formed on the front side electrode layer 5 to expose the front side electrode layer 5 in the termination region TR. Patterning of the Schottky contact metal layer 4 and of the front side electrode layer 5 as well as forming the recess 11 in the SiC layer 1 is performed in a single anisotropic etching process using the hard mask 46 as an etching mask. Accordingly, the anisotropic etching of the SiC material is performed by an etching process which has no etch selectivity against the metal of the Schottky contact metal layer 4 and the front side electrode layer 5. However, as the same etching mask is used to etch the Schottky contact metal layer 4, the front side electrode layer 5 and the SiC layer 1 in the step of anisotropic etching, the outer circumferential edges of the patterned Schottky contact metal layer 4' and of the patterned front side electrode layer 5' as well as the sidewall of the recess 11 in the SiC layer 1 are laterally (i.e. with respect to any lateral direction) aligned with each other. The anisotropic etching may for example be performed by RIE using a chlorine (Cl) based etching gas.

It will be apparent for persons skilled in the art that modifications of the above described embodiments are possible without departing from the idea of the invention as defined by the appended claims.

In the above embodiments the manufactured power semiconductor device is a Schottky diode. However, the power semiconductor device may be any other power semiconductor device that requires a front side electrode and an edge termination, such as a JBS rectifier or a pn diode, for example. Accordingly, while in the figures the patterned front side electrode layer 5' covers the whole active region AR, the patterned front side electrode layer 5' (first patterned metal layer in the claims) may cover only a part of the active region AR.

In the above described embodiments the SiC layer 1 is provided as a separate layer or wafer. However, the SiC layer may also be provided as an epi layer on a substrate layer that has a relatively high doping concentration. Exemplarily the doping concentration of a substrate layer may be higher than 10¹⁷ cm⁻³. In the above described embodiments the substrate layer would be arranged between SiC layer 1 and backside electrode layer 7.

In the Figures of all embodiments the angle formed by a sidewall of the recess 11, 31 and the first main side 2 is shown to be 90° but it may also be slightly smaller and also larger. Exemplarily, the angle formed by a sidewall of the recess 11,31 and the first main side 2 may vary in a range between 60° and 120°, exemplarily between 70° and 110°, more exemplarily between 80° and 100°.

In the first embodiment the photoresist mask 6 acts as an etching mask during the whole step of anisotropic etching of the SiC layer 1. At the end of the step of anisotropic etching of the SiC layer 1 there remains in the first embodiment a remaining portion 6' of the photoresist mask 6. However, the whole photoresist mask 6 may be removed during the step of anisotropic etching of the SiC layer 1. In such case the patterned front side electrode layer 5' acts as an etching mask in the step of anisotropic etching of the SiC layer 1 from the moment when the photoresist mask 36 is totally removed by the anisotropic etching. Material of the SiC layer 1 is removed in all areas where the SiC layer 1 is not covered by the patterned front side electrode layer 5' as in the above embodiments.

In the above described second embodiment a stepped recess 31 is formed in the termination region TR as shown in Fig. 3D. However, the photoresist mask 36 may be removed before the step of anisotropic etching of the SiC layer 1. In such modified second embodiment a recess 11 in the SiC layer 1 as shown in Fig. 1F would be formed in the step of anisotropic etching of the SiC layer 1.

In the above described embodiments the patterned Schottky contact metal layer 4' and the patterned front side electrode layer 5' are formed by means of an etching process using an etching mask. However, the patterned Schottky contact metal layer 4' and the patterned front side electrode layer 5' may also be formed without an etching mask by another process, e.g. by use of a shadow mask or be a lift-off process.

The above embodiments were explained with specific conductivity types. The conductivity types of the semiconductor layers in the above described embodiments might be switched, so that all layers which were described as p-type layers would be n-type layers and all layers which were described as n-type layers would be p-type layers.

It should be noted that the term "comprising" does not exclude other elements or steps and that the indefinite article "a" or "an" does not exclude the plural. Also elements described in association with different embodiments may be combined.

### List of reference signs

- 1: silicon carbide layer
- 2: first main side
- 3: second main side
- 4: Schottky contact metal layer
- 4': patterned Schottky contact metal layer (second patterned metal layer)
- 5: front side electrode layer (first continuous metal layer)
- 5': patterned front side electrode layer (first patterned metal layer)
- 6: photoresist mask (second etching mask)
- 6': portion of photoresist mask (remaining after the step of anisotropic etching of the SiC layer 1)
- 7: backside electrode layer
- 8: passivation layer
- 9: opening
- 11: recess
- 31: stepped recess
- 36: photoresist mask
- 38: patterned passivation layer
- 46: hard mask
- AR: active region
- ER: recess region
- d₁: depth of recess
- d₂: depth of stepped recess
- d_{R}: depth of recess
- d_{SiC}: layer thickness (of the SiC layer 1)
- TR: termination region

## Claims

1. A method for manufacturing a power semiconductor device, the method comprising the following steps:
providing a silicon carbide layer (1) having a first main side (2) and a second main side (3) opposite to the first main side (2), wherein the first and the second main side (2, 3) extend in parallel to a lateral direction and wherein the silicon carbide layer (1) comprises an active region (AR) and a termination region (TR) laterally surrounding the active region (AR);
forming a first patterned metal layer (5') on the first main side (2) of the silicon carbide layer (1) in the active region (AR), the first patterned metal layer (5') exposing the termination region (TR);
**characterized by** anisotropic etching of the silicon carbide layer (1) in areas where the silicon carbide layer (1) is exposed by the patterned first metal layer (5') to form a recess (11; 31) in the silicon carbide layer (1) in the termination region (TR).

2. The method according to claim 1, wherein the patterned first metal layer (5') is used as a first etching mask in the step of anisotropic etching of the silicon carbide layer (1).

3. The method according to claim 1 or 2, comprising a step of forming a second patterned metal layer (4') in direct contact with the silicon carbide layer (1) to form a Schottky contact with the silicon carbide layer (1), wherein the first patterned metal layer (5') is in direct contact with the second patterned metal layer (4') to form an ohmic contact with the second patterned metal layer (4').

4. The method according to any one of claims1 to 3, wherein the first patterned metal layer (5') is made of aluminium or nickel.

5. The method according to any one of claims 1 to 4, wherein a fluorine based etching gas is used in the step of anisotropic etching of the silicon carbide layer (1).

6. The method according to any one of claims 1 to 5, wherein forming the first patterned metal layer (5') is performed by deposition of metal through a shadow mask or by a lift-off technique.

7. The method according to any one of claims 1 to 5, wherein the step of forming the first patterned metal layer (5') comprises the following steps:
forming a first continuous metal layer (5) on the first main side (2) of the silicon carbide layer (1) in the active region (AR) and in the termination region (TR);
forming a second etching mask (6; 36; 46) on the first continuous metal layer (5) at least in the termination region (TR); and
etching of the first continuous metal layer (5) using the second etching mask (6; 36; 46) to form the first patterned metal layer (5').

8. The method according to claim 7, wherein the second etching mask (6; 36) is a photoresist mask or a hard mask.

9. The method according to claim 7 or 8, wherein etching of the first continuous metal layer (5) is anisotropic.

10. The method according to any one of claims 7 to 9, wherein a chlorine based etching gas is used in the step of etching of the first continuous metal layer (5).

11. The method according to claim 7 or 8, wherein etching of the first continuous metal layer (5) is isotropic.

12. The method according to any one of claims 7 to 11, wherein the second etching mask (6; 36) is removed before the step of anisotropic etching of the silicon carbide layer (1).

13. The method according to any one of claims 7 to 11, wherein the second etching mask (6; 36) is removed during the step of anisotropic etching of the silicon carbide layer (1).

14. The method according to any one of claims 1 to 13, wherein the doping concentration of the silicon carbide layer (1) is 10¹⁷ cm⁻³ or less, and
wherein in the step of etching the silicon carbide layer (1), the silicon carbide layer (1) is etched to a depth (d_{R}; d₂) of at least 30% of a layer thickness (d_{SiC}) of the silicon carbide layer (1), wherein the layer thickness (d_{SiC}) is a distance from the first main side (2) to the second main side (3) in a direction orthogonal to the first main side (2).

15. A power semiconductor device, the power semiconductor device comprising:
a silicon carbide layer (1), the silicon carbide layer (1) having a first main side (2) and a second main side (3) opposite to the first main side (2), wherein the first main side (2) and the second main side (3) extend in parallel to a lateral direction and wherein the silicon carbide layer (1) comprises an active region (AR) and a termination region (TR) laterally surrounding the active region (AR), wherein the silicon carbide layer (1) has a recess (11; 31), which is recessed from the first main side (2), in the termination region (TR); and
a first patterned metal layer (5') on a first main side (2) of the silicon carbide layer (1) in the active region (AR),
**characterized in that** a sidewall of the recess (11; 31) adjacent to the active region (AR) is aligned with a circumferential edge of the first patterned metal layer (5').
